# EUROPÄISCHE PATENTSCHRIFT

(11) **EP 0 635 938 B1**
(45) Veröffentlichungstag und Bekanntmachung des Hinweises auf die Patenterteilung: **15.04.1998**
(21) Anmeldenummer: 94890120.2
(22) Anmeldetag: 11.07.1994
(51) Int. Cl.: H03H 9/02

(54) **Piezoelektrisches Kristallelement**
Piezoelectric crystal element
Cristal piézoélectrique

(30) Priorität: 20.07.1993 AT 1442/93; 05.08.1993 AT 1564/93
(43) Veröffentlichungstag der Anmeldung: 25.01.1995
(73) Patentinhaber: AVL List GmbH, 8020 Graz (AT)
(72) Erfinder: Krempl, Peter W., Dr., A-8047 Graz/Ragnitz (AT); Wallnöfer, Wolfgang, A-8045 Graz (AT)
(74) Vertreter: Krause, Walter, Dr. Dipl.-Ing.

(56) Entgegenhaltungen:
- EP-A- 0 370 996
- EP-A- 0 407 163

## Beschreibung

Die Erfindung betrifft ein piezoelektrisches Kristallelement für akustische Oberflächenwellenanwendungen, mit einem Quarzsubstrat mit zumindest einer im wesentlichen ebenen Quarzoberfläche.

Für die Signalverarbeitung und Sensorik im Bereich von 30MHz bis 30 GHz werden im zunehmenden Maß akustische Oberflächenwellen (AOW bzw. SAW) verwendet. Diese bieten durch die Anwendung der Oberflächentechnologie einen weiten Bereich von Möglichkeiten der Signalanregung und -verarbeitung.

Die wichtigsten Kriterien für ein Substrat für SAW-Bauelemente sind hohe elektromechnische Kopplung und gute Temperaturstabilität der Laufzeit. Diese beiden Ziele lassen sich mit den bisher bekannten Möglichkeiten nur begrenzt vereinbaren.

Meist wird als Substrat ein monolithischer piezoelektrischer Kristall verwendet. Quarz bietet einen temperaturkompensierten Schnitt, jedoch nur schwache Kopplung, während Lithiumniobat und Lithiumtantalat stärkere Temperaturabhängigkeiten aufweisen. Andere Materialien, die die beiden Anforderungen besser vereinen, werden gegenwärtig untersucht, sind aber wegen der aufwendigen und schwierigen Kristallzucht noch nicht zu einem konkurrenzfähigen Preis in großen Mengen erhältlich; dazu gehören die Quarzhomöotypen AlPO₄ (Berlinit) und GaPO₄.

Da die Wellen nur wenige Wellenlängen in das Substrat eindringen, werden sie durch dünne Schichten auf der Oberfläche stark beeinflußt. In den bekannten Anordnungen wird meist entweder eine piezoelektrische Schicht auf einem nicht piezoelektrischen Substrat aufgebracht, um die Wellenanregung zu ermöglichen, wie z.B. bei EP-A-407,163, ZnO-Filmen auf Glas (O. YAMAZAKI et al., IEEE Trans. SU-27, 1976, 724) oder Silizium (F.S. Hickernell et al., IEEE Ultrasonics Symp. 1980, 104), oder aber ein dielektrischer Film dient zur Kompensation der Temperaturabhängigkeit, z.B. bei amorphem SiO₂ auf Lithiumtantalat (T.E. PARKER und H. WICHANSKY, J. Appl. Phys. 50, (1979), 1360).

Aufgabe der Erfindung ist es, ein piezoelektrisches Kristallelement mit hoher elektromechanischer Kopplung und guter Temperaturstabilität zu finden, das technisch günstig und effizient herstellbar ist.

Diese Aufgabe wird durch die Merkmale der Ansprüche gelöst.

Die Lösung besteht darin, daß die ebene Quarzoberfläche eine epitaktisch aufgewachsene Schicht aus einem zu Quarz homöotypen Kristall der Summenformel ABO₄ aufweist, wobei A für Al oder Ga und B für P oder As steht, sowie daß die Quarzoberfläche und die epitaktische Schicht annähernd dieselbe kristallographische Orientierung aufweisen.

Überraschenderweise konnte festgestellt werden, daß z.B. bereits eine sehr dünne epitaxiale GaPO₄-Schicht auf einer Quarzplatte dazu führt, bei bestimmten kristallographischen Orientierungen piezoelektrische Bauelemente zu finden, die deutlich bessere Eigenschaften als Quarz aufweisen, nämlich gute Temperaturstabilität verbunden mit einer hohen elektroakustischen Kopplung. Der positive Effekt der GaPO₄-Schicht ist erfindungsgemäß bereits bei einer Schichtdicke von einem 0,1 bis 200 µm, bzw. einem Viertel der Oberflächenwellenlänge ausgeprägt.

Bei Orientierungen, bei welchen die kristallographische x-Achse normal zur Sagittalebene steht, sogenannten X-Zylinder-Schnitten, in denen die Oberflächenwellen bei Quarzhomöotypen rein transversalen Charakter haben, wurde überraschenderweise festgestellt, daß die Kopplung in Schichtstrukturen sogar wesentlich höher ist als in reinen Quarz- oder GaPO₄-Elementen.

Da nur eine Schicht von wenigen µm Dicke auf einer geeigneten Quarzplatte aufwachsen muß, kommt es zu einer drastischen Verkürzung der Wachstumsdauer und erlaubt damit eine sehr effiziente Herstellung von Bauelementen, sowie eine äußerst sparsame Verwendung der wertvollen Rohstoffe, insbesondere von Gallium.

Durch die Fortschritte in der Quarzzucht sind als Keimlinge Wafer mit drei Zoll Durchmesser erhältlich. Ihre Verwendung ermöglicht die gleichzeitige Produktion zahlreicher Bauelemente, wobei die epitaktische Schicht erfindungsgemäß im Hydrothermalverfahren oder mit einem Sputterverfahren aufbringbar ist.

Gemäß einer vorteilhaften Ausführungsvariante der Erfindung ist vorgesehen, daß die epitaktische Schicht nur Teile der Quarzoberfläche bedeckt. Für manche Ausführungsvarianten, bei welchen sowohl auf eine erhöhte Kopplung bei den Wandlern als auch auf eine geringe Wellendämpfung durch das epitaktisch aufgetragene Substrat Wert gelegt wird, ist es von Vorteil, die epitaktische Schicht nur direkt im Bereich der Elektrodenstrukturen aufzutragen.

Die epitaktische Schicht kann im Hydrothermalverfahren aufgebracht werden, oder in einem Abscheideverfahren aus der Dampfphase wie z.B. chemische (CVD, Plasmaaktivierte CVD) oder physikalische Dampfabscheidung (Sputtern, Aufdampfen, Ionenplattieren).

Bei der Resonatoranwendung kann der Rand der epitaktischen Schicht für SAW-Reflexionen verendet werden. Erfindungsgemäß kann es dabei von Vorteil sein, wenn auf der Quarzoberfläche streifenförmige Bereiche mit einer zusätzlichen epitaktischen Schicht vorgesehen sind, welche zur Reflexion der Oberflächenwellen dienen.

Eine Weiterbildung der Erfindung sieht vor, daß die epitaktische Schicht in Vertiefungen der Quarzoberfläche angeordnet ist. Durch diese Versenkung in das Quarzsubstrat werden die in diesem Fall unerwünschten Reflexionen vermindert. Diese Ausführung verbindet damit die hohe Kopplung der epitaktischen Schicht mit der niedrigen Oberflächenwellendämpfung von Quarz.

Schließlich ist erfindungsgemäß vorgesehen, daß sich zwischen zumindest zwei mit epitaktischer Schicht bedeckten Teilen der Quarzoberfläche eine den Zwischenraum zumindest teilweise bedeckende, sensitive Schicht befindet, wobei sich die Phasengeschwindigkeit der akustischen Oberflächenwelle unter dem Einfluß einer zu messenden Größe ändert, und die zu messende Größe beispielsweise die NO₂-Konzentration ist. Gemäß einem Beispiel aus M. RAPP et al., Sensors and Actuators B, 4 (1991) 103 - 108 kann dabei als Schichtmaterial Phthalozyanin verwendet werden.

Die Beschränkung der epitaktischen Schicht auf Teilbereiche der Quarzoberfläche kann durch Maskierung bei der Schichtaufbringung oder durch teilweise Entfernung der Schicht durch Ätztechniken erreicht werden.

Erfindungsgemäß ist weiters vorgesehen, daß die epitaktische Schicht an deren Oberfläche Elektrodenstrukturen zur Anregung, zur Beeinflussung und/oder zum Empfang von akustischen Wellen, die sich parallel zur Oberfläche ausbreiten, aufweist. Zum Beispiel können mit üblichen Anlagen photolithographische Wandler, Reflektoren und andere Strukturen aufgebracht werden.

Eine weitere vorteilhafte Verwendung eines erfindungsgemäßen piezoelektrischen Kristallelementes als optoakustisches Bauelement sieht vor, daß die epitaktische Schicht als Lichtleiter dient.

Die Erfindung wird anhand von Ausführungsbeispielen näher erläutert. Es zeigen:
Fig. 1 und Fig. 2 erfindungsgemäße piezoelektrische Kristallelemente unterschiedlicher kristallographischer Orientierungen,
Fig. 3 einen Schnitt (A-A') durch das Kristallelement nach Fig. 1 oder 2,
Fig. 4 ein weiteres erfindungsgemäßes piezoelektrisches Kristallelement in einer Schnittdarstellung und die
Fig. 5 und 6 Ausführungsvarianten des Kristallelements nach Fig. 4.

Auf einem Substrat aus Quarz 1 befindet sich auf einer im wesentlichen ebenen Quarzoberfläche 1' eine epitaktisch aufgewachsene und im wesentlichen zu dieser gleich orientierte Schicht 2 aus einem zu Quarz homöotypen Kristall, z.B. eine GaPO₄-Schicht. Auf deren Oberfläche 2' sind photolithographisch Interdigitalwandler 3 oder andere Strukturen für die Anregung oder Beeinflussung von Oberflächenwellen aufgebracht. Die Wellenausbreitung erfolgt parallel zur Oberfläche 1' in der Schicht 2 sowie im obersten Teil des Quarzkristalls 1.

Die optimalen kristallographischen Orientierungen für eine Schichtstruktur, bestehend aus dem Quarzkristall 1 und der epitaktischen Schicht 2 sind nicht identisch mit jenen für einen Einkristall aus dem Schicht- oder Substratmaterial. Sie hängen außerdem wegen der Dispersion der Oberflächenwellen vom Verhältnis der Schichtdicke zur Wellenlänge ab. Für eine bestimmte Materialkombination können daher stets nur wenige Orientierungsbereiche angegeben werden. Es stellte sich heraus, daß für eine GaPO₄-Schicht auf Quarz in den folgenden Winkelbereichen eine hohe elektromechanische Kopplung und eine ausrechende Temperaturkompensation der Laufzeit bzw. Frequenz erreicht werden können:

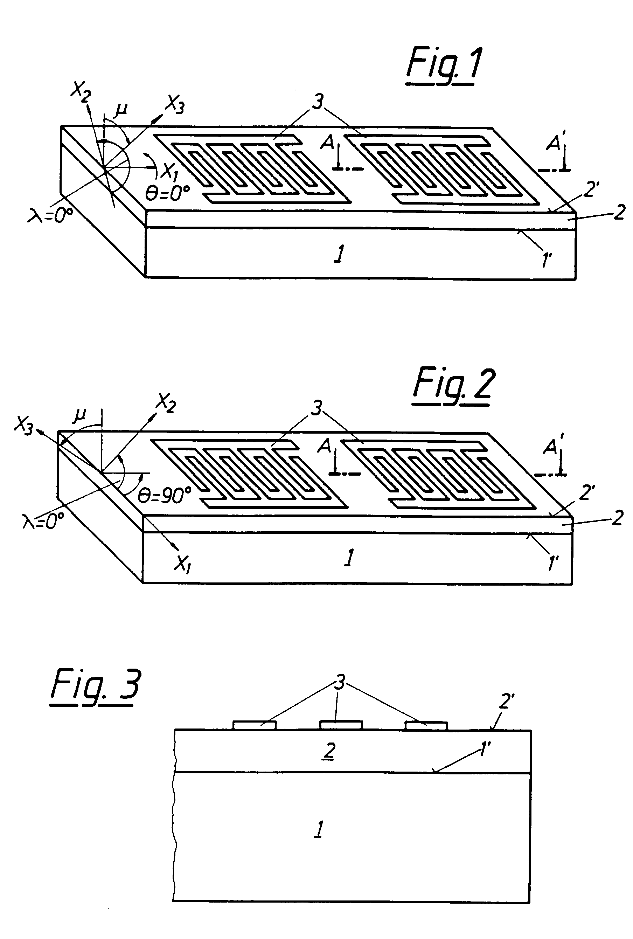

Die optimalen Orientierungen werden erreicht, wenn das Koordinatensystem, dessen x₁-Achse in Richtung des Wellenvektors zeigt und dessen x₃-Achse normal zu den Grenzflächen der Schicht steht, aus dem Koordinatensystem gemäß IEEE-Standard on Piecoelektricity 176 (1978) durch Drehung mit folgenden Eulerwinkeln hervorgeht:
λ = etwa 0°, µ = 50° bis 70° und θ = etwa 0°, oder mit folgenden Winkeln: λ = etwa 0°, µ = -20° bis 0° und θ = 90°. Beim ersten Satz zeigt die kristallographische x- bzw. x₁-Achse in Ausbreitungsrichtung der Welle (x-Boule-Orientierungen gemäß Fig. 1), bei letzterem normal zur Sagittalebene, die durch Ausbreitungsrichtung und Oberflächennormale aufgespannt wird (x-Zylinder-Orientierungen gemäß Fig. 2).

Bei AlPO₄ (Berlinit) auf Quarz liegen die optimalen Orientierungen in den folgenden Bereichen:
λ= etwa 0°, µ = 65° bis 90° und θ = etwa 0°, oder λ= etwa 0°, µ = -40° bis -20° oder 40° bis 60° und θ = etwa 90°.

Da z.B. eine epitaktische Schicht 2 aus GaPO₄ vom UV-Bereich bis weit in den Infrarotbereich transparent ist, kann sie in vorteilhafter Weise auch als Lichtwellenleiter benutzt werden. Eine Lichtwelle, die sich in der GaPO₄-Schicht 2 nahezu parallel zur Oberfläche 2' ausbreitet, wird sowohl an der Oberfläche 2', als auch an der Grenzfläche 1' zum Quarz 1 total reflektiert. Damit ist die Schichtstruktur für akustische Bauelemente geeignet, bei denen Licht durch Oberflächenwellen moduliert, gebeugt oder geschaltet wird.

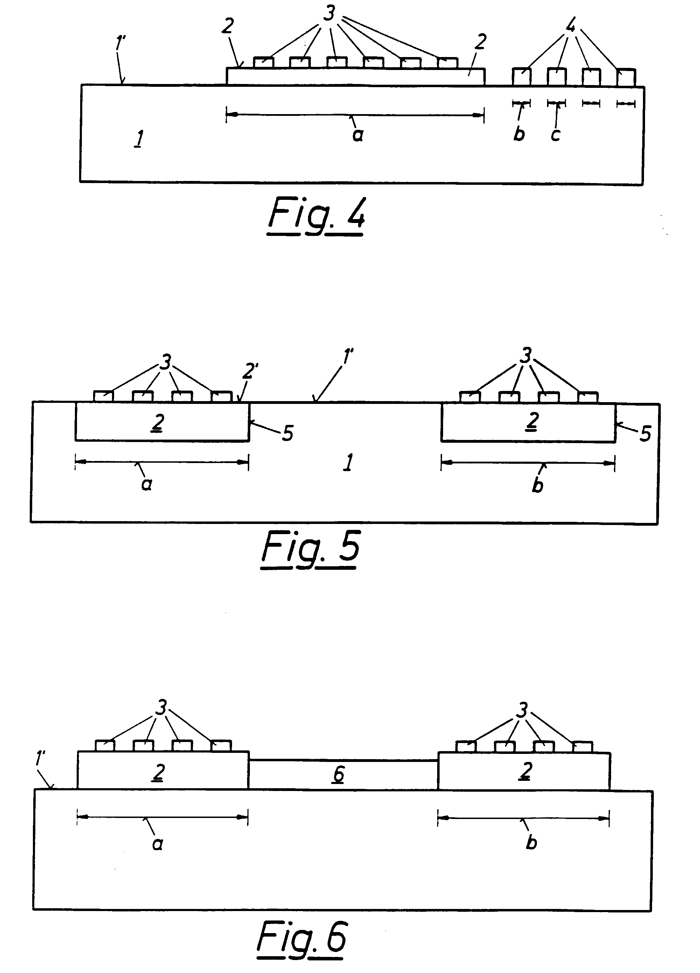

Gemäß einer Ausführungsvariante nach Fig. 4 befinden sich auf einem Substrat aus Quarz 1 auf einer im wesentlichen ebenen Quarzoberfläche 1' eine nur auf einem Teil a epitaktisch aufgewachsene und im wesentlichen zu dieser gleich orientierte Schicht 2 aus einem zu Quarz homöotypen Kristall, z.B. eine GaPO₄-Schicht. Auf deren Oberfläche 2' sind photolithographisch Interdigitalwandler 3 oder andere Strukturen für die Anregung oder Beeinflussung von Oberflächenwellen aufgebracht.

Die Wellenausbreitung erfolgt parallel zur Oberfläche 1' in der Schicht 2 sowie im obersten Teil des Quarzkristalls 1.

Die SAW-Reflexion an den Rändern der epitaktischen Schicht 2 sowie an zusätzlichen streifenförmigen Bereichen b, c mit einer epitaktischen Schicht 4 kann bei Resonatoranwendungen zu einer erhöhten Resonatorgüte führen.

In der Ausführung nach Fig. 5 bedeckt die epitaktische Schicht die Teile a und b und ist in Vertiefungen 5 der Quarzoberfläche 1' angebracht. Durch diese Versenkung wird die in diesem Fall nicht erwünschte Reflexion vermindert.

Bei der Ausführung nach Fig. 6 ist im Bereich ohne Epitaxieschicht 2 zwischen den Elektrodenstrukturen 3 eine sensitive Schicht 6 aufgebracht, deren SAW-Parameter sich unter dem Einfluß einer Meßgröße, z. B. der NO₂-Konzentration, ändern.

Als Beispiel kann das erfindungsgemäße Kristallelement wie folgt hergestellt werden:

Quarzwafer mit der vorgegebenen Orientierung werden in einem Zuchtautoklaven befestigt. Der Autoklav wird mit einer Zuchtlösung gefüllt. Durch zeitliche oder räumliche Variation der Temperatur wird auf den Wafern eine epitaktische GaPO₄-Schicht aufgebracht. Dies erfolgt bei hohen Temperaturen und Drücken. Nach Abfluß der Lösung werden die beschichteten Quarzplatten entnommen; die GaPO₄-Schichten werden auf die gewünschte Dicke geläppt und poliert. Mit Ätz- oder Lift-off-Technik werden photolithographisch Oberflächenwellen-Strukturen aus einer dünnen Metallschicht gebildet. Der Wafer wird dann zersägt, die einzelnen Elemente im Gehäuse befestigt und kontaktiert.

## Patentansprüche

1. Piezoelektrisches Kristallelement für akustische Oberflächenwellenanwendungen, mit einem Quarzsubstrat (1) mit zumindest einer im wesentlichen ebenen Quarzoberfläche (1'), **dadurch gekennzeichnet**, daß die ebene Quarzoberfläche (1') eine epitaktisch aufgewachsene Schicht (2) aus einem zu Quarz homöotypen Kristall der Summenformel ABO₄ aufweist, wobei A für Al oder Ga und B für P oder As steht, sowie daß die Quarzoberfläche (1') und die epitaktische Schicht (2) annähernd dieselbe kristallographische Orientierung aufweisen.

2. Piezoelektrisches Kristallelement nach Anspruch 1, **dadurch gekennzeichnet**, daß die epitaktische Schicht (2) aus GaPO₄ besteht und deren kristallographische Orientierung durch die Eulerwinkel λ im Bereich von 0°, µ im Bereich von 50 bis 70° und θ im Bereich von 0° bestimmt ist.

3. Piezoelektrisches Kristallelement nach Anspruch 1, **dadurch gekennzeichnet,** daß die epitaktische Schicht (2) aus GaPO₄ besteht, und deren kristallographische Orientierung durch die Eulerwinkel λ im Bereich von 0°, µ im Bereich von -20 bis 0° und θ im Bereich von 90° bestimmt ist.

4. Piezoelektrisches Kristallelement nach Anspruch 1, **dadurch gekennzeichnet,** daß die epitaktische Schicht (2) aus AlPO₄ besteht und deren kristallographische Orientierung durch die Eulerwinkel λ im Bereich von 0°, µ im Bereich von 65 bis 90° und θ im Bereich von 0° bestimmt ist.

5. Piezoelektrisches Kristallelement nach Anspruch 1, **dadurch gekennzeichnet**, daß die epitaktische Schicht (2) aus AlPO₄ besteht und deren kristallographische Orientierung durch die Eulerwinkel λ im Bereich von 0°, µ im Bereich von -40 bis -20° oder 40 bis 60° und θ im Bereich von 90° bestimmt ist.

6. Piezoelektrisches Kristallelement nach einem der Ansprüche 1 bis 5 **dadurch gekennzeichnet**, daß die epitaktische Schicht (2) nur Teile (a, b, c, ...) der Quarzoberfläche (1') bedeckt.

7. Piezoelektrisches Kristallelement nach Anspruch 6, **dadurch gekennzeichnet,** daß die epitaktische Schicht (2) in Vertiefungen (5) der Quarzoberfläche (1') angeordnet ist.

8. Piezoelektrisches Kristallelement nach Anspruch 6, **dadurch gekennzeichnet,** daß auf der Quarzoberfläche (1') streifenförmige Bereiche mit einer zusätzlichen epitaktischen Schicht (4) vorgesehen sind, welche zur Reflexion der Oberflächenwellen dienen.

9. Piezoelektrisches Kristallelement nach einem der Ansprüche 6 bis 8, **dadurch gekennzeichnet,** daß sich zwischen zumindest zwei mit epitaktischer Schicht (2) bedeckten Teilen (a, b) der Quarzoberfläche (1') eine den Zwischenraum zumindest teilweise bedeckende, sensitive Schicht (6) befindet, wobei sich die Phasengeschwindigkeit der akustischen Oberoberflächenwelle unter dem Einfluß einer zu messenden Größe ändert.

10. Piezoelektrisches Kristallelement nach Anspruch 9, **dadurch gekennzeichnet,** daß die zu messende Größe die NO₂-Konzentration ist.

11. Piezoelektrisches Kristallelement nach einem der Ansprüche 1 bis 10, **dadurch gekennzeichnet,** daß die Dicke der epitaktischen Schicht (2, 4) 0,1 bis 200 µm beträgt.

12. Piezoelektrisches Kristallelement nach einem der Ansprüche 1 bis 11, **dadurch gekennzeichnet,** daß die epitaktische Schicht (2) im Hydrothermalverfahren aufbringbar ist.

13. Piezoelektrisches Kristallelement nach einem der Ansprüche 1 bis 11, **dadurch gekennzeichnet,** daß die epitaktische Schicht (2) mit einem Sputterverfahren aufbringbar ist.

14. Piezoelektrisches Kristallelement nach einem der Patentansprüche 1 bis 5, **dadurch gekennzeichnet,** daß die epitaktische Schicht (2) an deren Oberfläche (2') Elektrodenstrukturen (3) zur Anregung, zur Beeinflussung und/oder zum Empfang von akustischen Wellen, die sich parallel zur Oberfläche ausbreiten, aufweist.

15. Verwendung eines piezoelektrischen Kristallelementes nach einem der Ansprüche 1 bis 5 als optoakustisches Bauelement, **dadurch gekennzeichnet,** daß die epitaktische Schicht (2) als Lichtleiter dient.

## Claims

1. Piezoelectric crystal element for surface acoustic wave applications, with a quartz substrate (1) with at least one substantially planar quartz surface (1'), **wherein** the planar quartz surface (1') has an epitaxially grown layer (2) of a quartz-isomorphous crystal with the total molecular formula ABO₄, A standing for Al or Ga, and B for P or As, and wherein the quartz surface (1') and the epitaxial layer (2) have approximately the same crystallographic orientation.

2. Piezoelectric crystal element as in claim 1, **wherein** the epitaxial layer (2) is made from GaPO₄, and its crystallographic orientation is defined by Euler angles λ in the range of 0°, µ in the range of 50° to 70°, and θ in the range of 0°.

3. Piezoelectric crystal element as in claim 1, **wherein** the epitaxial layer (2) is made from GaPO₄, and its crystallographic orientation is defined by Euler angles λ in the range of 0°, µ in the range of -20° to 0°, and θ in the range of 90°.

4. Piezoelectric crystal element as in claim 1, **wherein** the epitaxial layer (2) is made from AlPO₄, and its crystallographic orientation is defined by Euler angles λ in the range of 0°, µ in the range of 65° to 90°, and θ in the range of 0°.

5. Piezoelectric crystal element as in claim 1, **wherein** the epitaxial layer (2) is made from AlPO₄, and its crystallographic orientation is defined by Euler angles λ in the range of 0°, µ in the range of -40° to -20° or 40° to 60°, and θ in the range of 90°.

6. Piezoelectric crystal element as in any of claims 1 to 5, **wherein** the epitaxial layer (2) covers only parts (a, b, c, ...) of the quartz surface (1').

7. Piezoelectric crystal element as in claim 6, **wherein** the epitaxial layer (2) is deposited in recesses (5) of the quartz surface (1').

8. Piezoelectric crystal element as in claim 6, **wherein** strip-like regions with an additional epitaxial layer (4) are provided on the quartz surface (1'), which are designed to reflect the surface waves.

9. Piezoelectric crystal element as in any of claims 6 to 8, **wherein** between at least two parts (a, b) of the quartz surface (1') coated with an epitaxial layer (2) a sensitive layer (6) is provided, which covers the space in between at least partially, the phase velocity of the surface acoustic wave changing under the influence of a measurement variable.

10. Piezoelectric crystal element as in claim 9, **wherein** the measurement variable is NO₂ concentration.

11. Piezoelectric crystal element as in any of claims 1 to 10, **wherein** the thickness of the epitaxial layer 2, 4) is 0.1 to 200 micrometers.

12. Piezoelectric crystal element as in any of claims 1 to 11, **wherein** the epitaxial layer (2) is deposited by hydrothermal growth.

13. Piezoelectric crystal element as in any of claims 1 to 11, **wherein** the epitaxial layer (2) is deposited by a sputtering technique.

14. Piezoelectric crystal element as in any of claims 1 to 5, **wherein** electrode structures (3) are provided on the surface (2') of the epitaxial layer (2) for the purpose of exciting, influencing and/or receiving acoustic waves propagating parallel to the surface.

15. Use of a piezoelectric crystal element as in any of claims 1 to 5 as an opto-acoustic component, **wherein** the epitaxial layer (2) serves as a waveguide for light.

## Revendications

1. Elément cristallin piézo-électrique pour des applications dans le domaine des ondes de surface acoustiques, comprenant un substrat de quartz (1) avec au moins une surface de quartz (1') sensiblement plane, caractérisé en ce que la surface de quartz (1') plane présente une couche (2) obtenue par croissance épitaxiale, constituée d'un cristal d'un type homologue du quartz, ayant la formule générale ABO₄, dans laquelle A représente Al ou Ga et B représente P ou As, et en ce que la surface de quartz (1') et la couche épitaxiale (2) présentent approximativement la même orientation cristallographique.

2. Elément cristallin piézo-électrique selon la revendication 1, caractérisé en ce que la couche épitaxiale (2) est constituée de GaPO₄ et en ce que son orientation cristallographique, déterminée par les angles d'Euler, est comme suit : λ au voisinage de 0°, µ dans la plage de 50 à 70° et θ au voisinage de 0°.

3. Elément cristallin piézo-électrique selon la revendication 1, caractérisé en ce que la couche épitaxiale (2) est constituée de GaPO₄ et en ce que son orientation cristallographique, déterminée par les angles d'Euler, est comme suit : λ au voisinage de 0°, µ dans la plage de - 20 à 0° et θ au voisinage de 90°.

4. Elément cristallin piézo-électrique selon la revendication 1, caractérisé en ce que la couche épitaxiale (2) est constituée de AlPO₄ et en ce que son orientation cristallographique, déterminée par les angles d'Euler, est comme suit : λ au voisinage de 0°, µ dans la plage de 65 à 90° et θ au voisinage de 0°.

5. Elément cristallin piézo-électrique selon la revendication 1, caractérisé en ce que la couche épitaxiale (2) est constituée de AlPO₄ et en ce que son orientation cristallographique, déterminée par les angles d'Euler, est comme suit : λ au voisinage de 0°, µ dans la plage de - 40 à - 20° ou de 40 à 60° et θ au voisinage de 90°.

6. Elément cristallin piézo-électrique selon l'une des revendications 1 à 5, caractérisé en ce que la couche épitaxiale (2) ne couvre qu'une partie (a, b, c, ...) de la surface de quartz (1').

7. Elément cristallin piézo-électrique selon la revendication 6, caractérisé en ce que la couche épitaxiale (2) est formée dans des évidements (5) de la surface de quartz (1').

8. Elément cristallin piézo-électrique selon la revendication 6, caractérisé en ce que, sur la surface de quartz (1'), il est prévu des zones formant des bandes avec une couche épitaxiale (4) additionnelle, servant à la réflexion des ondes de surface.

9. Elément cristallin piézo-électrique selon une des revendications 6 à 8, caractérisé en ce que, entre au moins deux parties (a, b) couvertes d'une couche épitaxiale (2) de la surface de quartz (1'), il y a une couche sensible intermédiaire (6), au moins partiellement couverte, grâce à quoi que la vitesse des phases de l'onde de surface acoustique se modifie sous l'effet d'une grandeur à mesurer.

10. Elément cristallin piézo-électrique selon la revendication 9, caractérisé en ce que la grandeur à mesurer est la concentration en NO₂.

11. Elément cristallin piézo-électrique selon une des revendications 1 à 10, caractérisé en ce que l'épaisseur de la couche épitaxiale (2, 4) se situe dans la plage allant de 0,1 à 200 µm.

12. Elément cristallin piézo-électrique selon une des revendications 1 à 11, caractérisé en ce que la couche épitaxiale (2) est réalisée par un procédé hydrothermique.

13. Elément cristallin piézo-électrique selon une des revendications 1 à 11, caractérisé en ce que la couche épitaxiale (2) est réalisée par un procédé de pulvérisation.

14. Elément cristallin piézo-électrique selon une des revendications 1 à 5 du brevet, caractérisé en ce que la couche épitaxiale (2) présente sur sa surface externe (2'), des structures d'électrodes (3) disposées parallèlement à ladite surface externe, qui sont excitées, influencées et/ou capables de recevoir des ondes acoustiques.

15. Utilisation d'un élément cristallin piézo-électrique selon une des revendications 1 à 5, comme élément d'une structure opto-acoustique, caractérisée en ce que la couche épitaxiale (2) sert de guide optique.
